# EUROPEAN PATENT SPECIFICATION

(11) **EP 3 422 376 B1**
(45) Date of publication and mention of the grant of the patent: **01.12.2021**
(21) Application number: 17178964.7
(22) Date of filing: 30.06.2017
(51) Int. Cl.: H01G 11/08, H01G 11/32, H01G 11/82, H05K 1/16, H05K 1/02

(54) **SUPERCAPACITOR ASSEMBLY FOR PORTABLE ELECTRONIC DEVICES, AND METHOD OF GEOLOCALIZATION OF THE PORTABLE DEVICE**
SUPERKONDENSATORANORDNUNG FÜR TRAGBARE ELEKTRONISCHE VORRICHTUNGEN UND VERFAHREN ZUR GEOLOKALISIERUNG DER TRAGBAREN ELEKTRONISCHEN VORRICHTUNG
SUPERCONDENSATEUR POUR DISPOSITIFS ÉLECTRONIQUES PORTATIFS ET MÉTHODE DE GÉOLOCALISATION DUDIT DISPOSITIF PORTABLE

(43) Date of publication of application: 02.01.2019
(73) Proprietor: Vestel Elektronik Sanayi ve Ticaret A.S., 45030 Manisa (TR); Ozyegin Universitesi, 34794 Istanbul (TR)
(72) Inventor: MEMISOGLU, Görkem, 45030 Manisa (TR); GÜLBAHAR, Burhan, 34794 Çekmeköy / Istanbul (TR)
(74) Representative: Kehl, Ascherl, Liebhoff & Ettmayr Patentanwälte Partnerschaft mbB

(56) References cited:
- EP-A1- 0 887 779
- EP-A1- 3 038 177
- EP-A1- 3 096 389
- CN-A- 106 781 323
- KR-A- 20160 019 170
- KR-B1- 101 582 768
- US-A1- 2016 105 207
- US-A1- 2016 204 492

## Description

The present invention relates to a portable electronic device according to claim 1, and a method of operating a portable electronic device according to claim 10.

### Background of the Invention

Supercapacitors differ from conventional capacitors (including electrolytic capacitors) in having an electrode with an electrolytic or ionic material in contact with the electrode. The electrode may have a very high specific surface area, for example because of nanopores in the electrode, and the electrolytic or ionic material contains ions which are able to be transported into contact with the surface of the electrode to create a very high specific charge density at the surface of the electrode. In some cases, the supercapacitor may comprise a pair of electrodes, with an ion-permeable membrane separating the two electrodes, and the ions are able to be transported between the two electrodes across the ion-permeable membrane. Since supercapacitors can be made very thin without breakthrough of charge carriers between the two electrodes, supercapacitors can achieve specific energy and power storage values very much higher than conventional electrolytic capacitors. They have therefore found numerous applications in recent years in a wide range of devices, including in portable electronic devices.

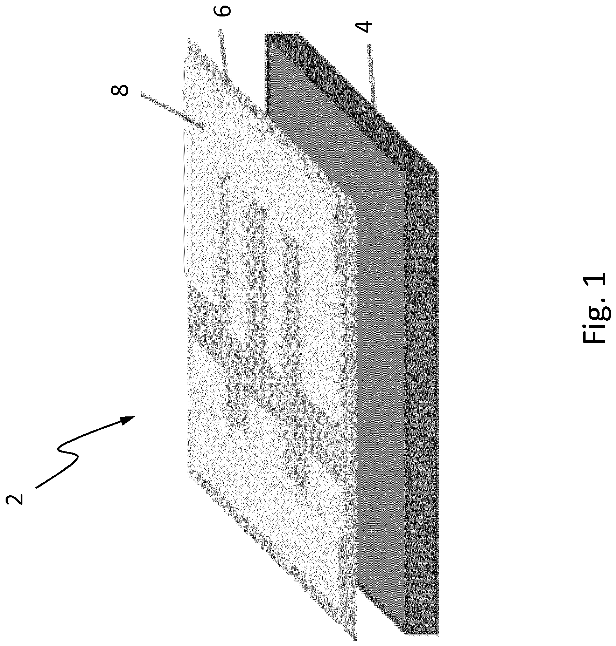

Like conventional electrolytic capacitors, the capacitance of supercapacitors can be increased by increasing the surface area of their electrodes. Supercapacitors of higher capacitance have therefore generally been made by rolling a long strip of thin supercapacitor into a cylinder, or by stacking a plurality of thin supercapacitors together, and then packaging the resulting product in either case into an enclosure provided with electrically conducting contacts. For example, WO 2014/072877 describes a supercapacitor with electrodes formed on a hard carbon fabric substrate assembled in a stainless steel cell with titanium electrical contacts (see example 2 and Fig. 1a thereof), as well as a supercapacitor with electrodes formed on a flexible carbon substrate encapsulated within a laminated pouch (see example 3 and Fig. 1b thereof). In both cases, the packaged supercapacitor can then be mounted on or connected to a circuit board as a discrete electronic component. Conversely, this also means that the packaged supercapacitor can in either case also be easily removed or detached from the circuit board.

The use of supercapacitors in portable electronic devices, such as in mobile phones, is also known, and is described, for example, in WO 2016/207805. This document discloses a method of locating a battery-powered mobile phone or a Bluetooth™ headset device, either of which comprises a supercapacitor in addition to a battery. According to this method, if the battery is dead, electrical energy stored in the supercapacitor can be used to power an ultra-low power acoustic transceiver, for the emission of an audible signal, such as a loud beeping sound, which is able to guide a user to find the mobile phone or Bluetooth™ headset device.

However, if a portable electronic device comprising a removable and rechargeable battery is lost or stolen and if the battery is removed from the device or is dead, the supercapacitor can also easily be removed from the device, thereby depriving the portable electronic device of a reserve supply of electrical power stored in the supercapacitor which could otherwise be used to relocate the device.

US 2016/0105207 describes a case for a mobile device, such as a mobile phone, wherein the case is provided with GPS tracking. The mobile device has a first (phone) battery to operate, and the mobile device case comprises a housing to receive the mobile device, with a second (case) battery embedded in the housing. A pair of thermometers embedded in the housing monitor the temperature of the first (phone) battery and ambient conditions surrounding the housing. A GPS device in the housing determines the location of the mobile device case, an electronic communication means in the housing sends and receives data relating to the location of the mobile device case, and a processor in the housing swiches the power source of the mobile device from the first (phone) battery to the second (case) battery when the first battery is dead.

### Object of the Invention

It is therefore an object of the invention to provide a portable electronic device, and a method of operating a portable electronic device.

### Description of the Invention

The object of the invention is solved by a portable electronic device according to claim 1. The portable electronic device at least comprises an enclosure, a main circuit board contained therein, a position-locating module, and a radio-frequency telecommunications module, wherein the main circuit board comprises an area to accommodate a removable and rechargeable battery. The main circuit board comprises a supercapacitor assembly at least comprising a substrate, a supercapacitor formed on the substrate, and a planar electrically conducting contact formed on the supercapacitor. The substrate is able to have an electrical circuit formed thereon. The supercapacitor comprises a layer of two-dimensional material and an electrolyte in contact therewith, and is permanently bonded to the substrate. The supercapacitor assembly is located outside the battery-accommodating area.

As used herein, the term "two-dimensional material" means a material having a macroscopic size in two dimensions, but little or substantially no thickness. On the other hand, the two-dimensional material may comprise zero-dimensional constituents, such as quantum dots, one-dimensional constituents, such as nanotubes, two-dimensional constituents, such as layers, constituents which are fractal-like and therefore have a fractional dimension, or any combination of zero-, one-, two- and fractional dimensional constituents.

The planar electrically conducting contact can act as a current collector for the supercapacitor.

The supercapacitor can be permanently bonded to the substrate by being formed on the substrate by any appropriate known method of material deposition, such as screen printing, chemical vapour deposition (CVD) and vacuum thermal deposition.

This solution is beneficial because the permanent bonding of the supercapacitor to the substrate makes it impossible to remove the supercapacitor from the substrate without destroying the supercapacitor and/or damaging the substrate and any electrical circuit formed thereon. Thus the supercapacitor cannot be easily removed from a portable electronic device comprising such a supercapacitor assembly without significantly damaging or destroying both the value of the device and the ability of the device to function normally.

Advantageous embodiments of the invention may be configured according to any claim and/or part of the following description.

According to one possible preferred embodiment, an electrical circuit is formed on the substrate comprising at least one additional discrete electronic component mounted on the substrate beside the supercapacitor. Thus the supercapacitor may be included in an electrical circuit as an integral part thereof.

The substrate may comprise a semiconductor material, such as silicon. Alternatively or additionally, the substrate may comprise a thermoplastic polymer material, such as polyethylene terephthalate (PET). Preferably, the substrate is rigid so that it may be used for mounting a plurality of different discrete electronic components thereto. However, the substrate could, in an alternative embodiment, be flexible instead.

Preferably, the two-dimensional material comprises at least one of activated carbon, carbon fibres, carbide-derived carbon, graphene, graphane and carbon nanotubes. These materials are preferred because they can achieve high specific energy and power storage densities.

In one possible preferred embodiment, the supercapacitor may comprise a plurality of layers of two-dimensional material, one on top of another, with an electrolyte between each adjacent pair of layers. This solution is beneficial because it can be used to increase the energy and power storage values of the supercapacitor without substantially increasing its thickness or affecting its permanent bonding to the substrate.

Preferably, the electrolyte comprises at least one of a gel electrolyte and a liquid crystal.

As used herein, the term "main circuit board" means the largest of several circuit boards (usually referred to as the "mother board") if the electronic device comprises a plurality of circuit boards or otherwise the only circuit board if the electronic device comprises only a single circuit board. The term "circuit board" as used herein encompasses both rigid and flexible varieties thereof.

This solution is beneficial because if a portable electronic device comprises a supercapacitor assembly as described herein as part of the main circuit board, the supercapacitor can be used to provide electrical power to some or all of the electronic components of the device in the event that a removable and rechargeable battery is removed from the device or is dead. On the other hand, since the supercapacitor is permanently bonded to the main circuit board, the supercapacitor cannot also be removed from the device without significantly damaging or destroying both the value of the device and the ability of the device to function normally. It is important that the supercapacitor assembly should form part of the main circuit board of the device rather than of a subsidiary circuit board, since a subsidiary circuit board might otherwise be disconnected from the main circuit board, allowing the device to continue to operate with reduced functionality.

Because the main circuit board comprises an area to accommodate a removable and rechargeable battery, and the supercapacitor assembly is located outside the battery-accommodating area, the supercapacitor more difficult to identify, locate and access, and therefore less liable to tampering.

In a possible preferred embodiment, the supercapacitor is able to provide electrical power to the position-locating module and to the telecommunications module for at least 1 minute, more preferably at least two minutes, and most preferably at least 5 minutes. The position-locating module may, for example, be a global navigation satellite system (GNSS) module, such as a Global Positioning System (GPS) receiver, or may alternatively comprise an accelerometer, a gyroscope and an electronic compass. The radio-frequency telecommunications module may, for example, be a cellular telephone transceiver module, such as a Global System for Mobile Communications (GSM) module. The position-locating module and the radio-frequency telecommunications module may be embodied in one-and-the-same element of the device, for example if the radio-frequency telecommunications module is a cellular telephone transceiver module, which is able to triangulate the position of the electronic device from cellular telephone base stations.

This solution is beneficial because the position-locating module and the radio-frequency telecommunications may be used to locate and transmit the position of the device using electrical power supplied by the supercapacitor in the event that the portable electronic device is lost or stolen and a removable and rechargeable battery is removed from the device or is dead.

The present invention further relates to a method of operating a portable electronic device as described herein wherein the method at least comprises providing the device with a removable and rechargeable battery, providing electrical power from the supercapacitor to the position-locating module and to the telecommunications module, finding a position of the device via the position-locating module, and transmitting the position of the device found by the position-locating module via the telecommunications module.

This solution is beneficial because in this way, the portable electronic device may be relocated and recovered in the event that the device is lost or stolen, and the relocation and recovery of the device cannot be defeated by removing the supercapacitor without also significantly damaging or destroying both the value of the device and the ability of the device to function normally.

The method may further comprise electrically charging the supercapacitor from the removable and rechargeable battery before the supercapacitor provides electrical power to the position-locating module and to the telecommunications module, although the supercapacitor may alternatively or additionally be electrically charged from a mains source of electrical power if the portable electronic device is plugged into such a mains source of electrical power to recharge the battery.

Locating the supercapacitor assembly on the main circuit board outside an area for accommodating the removable and rechargeable battery makes the supercapacitor assembly more difficult to identify, locate and access, and therefore less liable to tampering.

Preferably, the method further comprises receiving a position request via the radio-frequency telecommunications module before finding the position of the device via the position-locating module and transmitting the position of the device found by the position-locating module via the radio-frequency telecommunications module to a source of the request. This solution is beneficial because the device will then only transmit its position if requested to do so, thereby saving electrical energy stored in the supercapacitor until the source of the request is able to receive it.

Preferably, the method further comprises determining that the battery is unable to provide electrical power to at least one of the position-locating module and the radio-frequency telecommunications module before providing electrical power from the supercapacitor to at least one of the position-locating module and the telecommunications module. This solution is beneficial because the device will then only transmit its position using electrical power supplied by the supercapacitor if it is unable to use electrical power supplied by the battery, thereby saving the electrical energy stored in the supercapacitor until electrical energy stored in the battery is unavailable.

The present invention further relates to a computer program product or a program code or system for executing one or more than one of the herein described methods.

Further features, goals and advantages of the present invention will now be described in association with the accompanying drawings, in which exemplary components of the invention are illustrated. Components of the devices and methods according to the invention which are at least essentially equivalent to each other with respect to their function can be marked by the same reference numerals, wherein such components do not have to be marked or described in all of the drawings.

In the following description, the invention is described by way of example only with respect to the accompanying drawings.

### Brief Description of the Drawings

Fig. 1 is an exploded isometric view schematically showing a supercapacitor assembly comprising a two-dimensional supercapacitor formed on a substrate; and
Fig. 2 is a schematic plan view of the inside of a portable electronic device.

### Detailed Description of the Drawings

Fig. 1 schematically shows an assembly 2 comprising a two-dimensional supercapacitor. The assembly 2 comprises a substrate 4 able to receive a printed circuit, a supercapacitor 6 comprising a two-dimensional material with an electrolytic or ionic material in contact therewith, and a plurality of electrically conducting contacts 8. In Fig. 1, the substrate 4 and the supercapacitor 6 have been shown separately from each other for the purposes of improved clarity of illustration. However, in practice, the substrate 4 and the supercapacitor 6 are permanently bonded together, and are therefore actually in contact with each other. The substrate 4 can, for example, be a semiconductor substrate, such as one which is based on silicon, or a thermoplastic polymer-based substrate, such as comprises polyethylene terephthalate (PET). One or more additional discrete electronic components, such as resistors, transducers, capacitors of a conventional type, data processing or memory chips, may be mounted on the substrate 4 beside the supercapacitor 6, and the supercapacitor 6 may be connected to these one or more additional discrete electronic components via suitable circuitry formed on the substrate.

The supercapacitor 6 comprises two layers of two-dimensional material, with an electrolytic or ionic material therebetween, containing ions which are able to be transported between the two layers. The two-dimensional material may comprise activated carbon, carbon fibres, carbide-derived carbon, graphene, graphane (which is hydrogenated graphene) or carbon nanotubes. The two-dimensional material can be deposited on the substrate 4 by screen printing, chemical vapour deposition (CVD), vacuum thermal deposition or by another known coating technique. For example, WO 2016/073171 describes methods of printing graphene-based supercapacitor electrodes on a substrate. The electrolytic or ionic material between the two electrodes may comprise a gel electrolyte or a liquid crystal, for example.

The electrically conducting contacts 8 are also substantially flat and planar, and may comprise one or more of gold, silver, titanium, aluminium and copper, for example. The supercapacitor 6 is therefore sandwiched between the substrate 4 and the one or more electrically conducting contacts 8 to provide a microsupercapacitor which is permanently bonded to the substrate 4 and which, together with its electrically conducting contacts 8 formed thereon, is so thin that, to all intents and purposes, it is two-dimensional. The substrate 4, on the other hand, may be of any thickness, according to requirements, and may also be rigid.

Since the supercapacitor 6 is substantially flat and is permanently bonded to the substrate 4, it is impossible to remove the supercapacitor 6 from the substrate 4 without destroying the supercapacitor 6 and/or damaging the substrate 4 and any electrical circuit formed thereon.

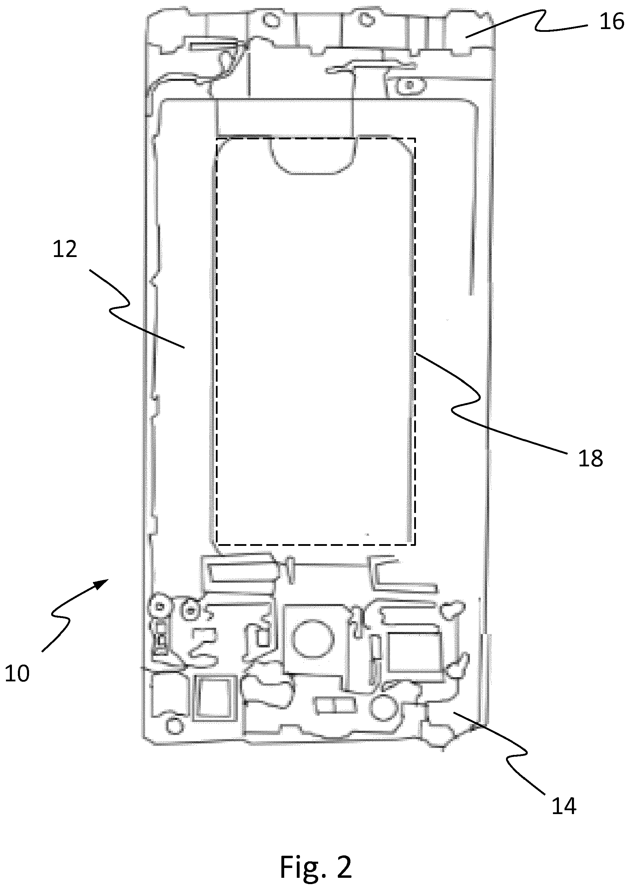

Fig. 2 schematically shows the inside of a portable electronic device 10. The portable electronic device 10 may, for example, be any one of a mobile phone, a laptop or tablet computer, a phablet (that is, a phone-sized tablet computer), a personal digital assistant (PDA), a games console, a portable media player, a satellite navigational device, and so on. In the example shown in Fig. 2, the portable electronic device 10 is a mobile phone, which comprises an enclosure containing a main circuit board 12, on which are mounted a first set of discrete components in a first area 14 and a second set of discrete components in a second area 16. The discrete components may comprise any of one or more user-operable buttons, a central processing unit, a video processing unit, a sound processing unit, a microphone, an accelerometer, a gyroscope, an electronic compass, a radio-frequency telecommunications module, a camera, an image sensor, a flashlight, an auto-focus actuator, a loudspeaker, one or more memory chips, and so on, as well as other passive components, such as resistors and conventional dielectric capacitors. Between the first and second areas 14, 16 of the discrete components, there is generally a third area 18, which is shown in dashed outline in Fig. 2 and which is intended to accommodate a removable and rechargeable battery, such as a lithium-ion battery, for powering the components of the mobile electronic device 10 during its normal operation.

According to the invention, a supercapacitor assembly of the type shown and described above in relation to Fig. 1 can be provided inside an enclosure of a portable electronic device, such as that shown in Fig. 2, as part of the main circuit board 12 of the device 10. If the supercapacitor assembly 2 is located outside the battery-accommodating area 18, then the supercapacitor assembly 2 can be made less accessible to external interference than if the supercapacitor assembly 2 were to be located within the battery-accommodating area 18.

If the portable electronic device 10 comprises a position-locating module and a radio-frequency telecommunications module, the supercapacitor assembly 2 can provide electrical power to the position-locating module and to the telecommunications module for at least 1 minute, but preferably for up to about 5 minutes, so that the device 10 can be located and retrieved even if the battery is removed from the device 10. On the other hand, since the supercapacitor 6 is permanently bonded to the substrate 4, the supercapacitor 6 cannot be removed from the device 10 to prevent its relocation and recovery without substantially damaging the device 10 and its ability to operate normally, and therefore without also significantly damaging the value of the portable electronic device 10.

In order to preserve the electrical energy stored in the supercapacitor 6, the position of the device 10 may only be transmitted after receiving a position request via the radio-frequency telecommunications module. The electrical energy stored in the supercapacitor 6 may also be preserved by firstly checking that the battery is unable to provide electrical power to at least one of the position-locating module and the radio-frequency telecommunications module before providing electrical power from the supercapacitor 6.

In summary, therefore, the present invention provides a portable electronic device comprising a supercapacitor assembly, wherein the supercapacitor assembly at least comprises a substrate, a supercapacitor formed on the substrate, and a planar electrically conducting contact formed on the supercapacitor. The substrate is able to have an electrical circuit formed thereon. The supercapacitor comprises a layer of two-dimensional material and an electrolyte in contact therewith, and is permanently bonded to the substrate. This arrangement prevents the supercapacitor from being removed from the substrate without destroying the supercapacitor and/or damaging the substrate and any electrical circuit formed thereon. Thus the supercapacitor cannot be easily removed from a portable electronic device comprising such a supercapacitor assembly without significantly damaging or destroying both the value of the device and the ability of the device to function normally. The invention also provides a portable electronic device at least comprising an enclosure containing a main circuit board comprising such a supercapacitor assembly. The invention further provides a method of operating such a portable electronic device which also comprises a removable and rechargeable battery and a position-locating module, such as a GPS receiver, and a radio-frequency telecommunications module, such as a cellular telephone transceiver, which may therefore be used to find and transmit the location of the device using electrical power supplied by the supercapacitor, even if the battery is removed from the device or is dead, with a very much reduced risk that the supercapacitor will be removed from the device as well.

**Reference Numerals:**

| | | | |
|---|---|---|---|
| 2 | Supercapacitor assembly | 12 | Main circuit board of portable electronic device |
| 4 | Substrate | | |
| 6 | Supercapacitor of two-dimensional material with electrolytic or ionic material | 14 | First area of discrete components on main circuit board |
| 8 | Electrically conducting contact | 16 | Second area of discrete components on main circuit board |
| 10 | Inside of portable electronic device | | |
| | | 18 | Area to accommodate removable battery |

## Claims

1. A portable electronic device (10) at least comprising:
an enclosure;
a main circuit board (12) contained therein;
a position-locating module; and
a radio-frequency telecommunications module;
wherein the main circuit board (12) comprises an area (18) to accommodate a removable and rechargeable battery;
**characterized in that**:
the main circuit board (12) comprises a supercapacitor assembly (2) at least comprising:
a substrate (4) able to have an electrical circuit formed thereon;
a supercapacitor (6) formed on the substrate (4) and comprising a layer of two-dimensional material and an electrolyte in contact therewith; and
a planar electrically conducting contact (8) formed on the supercapacitor (6);
wherein the supercapacitor (6) is permanently bonded to the substrate (8); and
the supercapacitor assembly (2) is located outside the battery-accommodating area (18).

2. A portable electronic device according to claim 1, wherein an electrical circuit is formed on the substrate (4) comprising at least one additional discrete electronic component mounted on the substrate (4) beside the supercapacitor (6).

3. A portable electronic device according to claim 1 or claim 2, wherein the substrate (4) comprises a semiconductor material.

4. A portable electronic device according to any one of claims 1 to 3, wherein the substrate (4) comprises a thermoplastic polymer material.

5. A portable electronic device according to any one of claims 1 to 4, wherein the substrate (4) is rigid.

6. A portable electronic device according to any one of claims 1 to 5, wherein the two-dimensional material comprises at least one of activated carbon, carbon fibres, carbide-derived carbon, graphene, graphane and carbon nanotubes.

7. A portable electronic device according to any one of claims 1 to 6, wherein the supercapacitor (6) comprises a plurality of layers of two-dimensional material, one on top of another, with an electrolyte between each adjacent pair of layers.

8. A portable electronic device according to any one of claims 1 to 7, wherein the electrolyte comprises at least one of a gel electrolyte and a liquid crystal.

9. A portable electronic device according to any one of the preceding claims, wherein the supercapacitor (6) is able to provide electrical power to the position-locating module and to the telecommunications module for at least 1 minute.

10. A method of operating a portable electronic device (10) according to any one of claims 1 to 9, the method at least comprising:
providing the device (10) with a removable and rechargeable battery;
providing electrical power from the supercapacitor (6) to the position-locating module and to the telecommunications module;
finding a position of the device (10) via the position-locating module; and
transmitting the position of the device found by the position-locating module via the telecommunications module.

11. A method according to claim 10, further comprising receiving a position request via the radio-frequency telecommunications module before finding the position of the device (10) via the position-locating module and transmitting the position of the device found by the position-locating module via the radio-frequency telecommunications module to a source of the request.

12. A method according to claim 10 or claim 11, further comprising determining that the battery is unable to provide electrical power to at least one of the position-locating module and the radio-frequency telecommunications module before providing electrical power from the supercapacitor (6) to at least one of the position-locating module and the telecommunications module.

## Patentansprüche

1. Tragbare elektronische Vorrichtung (10), die mindestens aufweist:
eine Hülle;
eine darin enthaltene Hauptleiterplatte (12)
ein Modul zur Positionsbestimmung; und
ein Hochfrequenz-Telekommunikationsmodul;
wobei die Hauptleiterplatte (12) einen Bereich (18) zur Aufnahme einer herausnehmbaren und wiederaufladbaren Batterie aufweist;
**dadurch gekennzeichnet, dass**:
die Hauptleiterplatte (12) eine Superkondensatorbaugruppe (2) aufweist, die zumindest Folgendes aufweist:
ein Substrat (4), auf dem eine elektrische Schaltung ausgebildet werden kann;
einen Superkondensator (6), der auf dem Substrat (4) ausgebildet ist und eine Schicht aus zweidimensionalem Material und einen Elektrolyten in Kontakt mit dieser aufweist; und
einen planaren elektrisch leitenden Kontakt (8), der auf dem Superkondensator (6) ausgebildet ist;
wobei der Superkondensator (6) dauerhaft mit dem Substrat (8) verbunden ist; und
die Superkondensatoranordnung (2) sich außerhalb des Batterieaufnahmebereichs (18) befindet.

2. Tragbare elektronische Vorrichtung gemäß Anspruch 1, wobei eine elektrische Schaltung auf dem Substrat (4) ausgebildet ist, die mindestens ein zusätzliches diskretes elektronisches Bauteil aufweist, das neben dem Superkondensator (6) auf dem Substrat (4) angebracht ist.

3. Tragbare elektronische Vorrichtung gemäß Anspruch 1 oder Anspruch 2, wobei das Substrat (4) ein Halbleitermaterial aufweist.

4. Tragbare elektronische Vorrichtung gemäß einem der Ansprüche 1 bis 3, wobei das Substrat (4) ein thermoplastisches Polymermaterial aufweist.

5. Tragbare elektronische Vorrichtung gemäß einem der Ansprüche 1 bis 4, wobei das Substrat (4) starr ist.

6. Tragbare elektronische Vorrichtung gemäß einem der Ansprüche 1 bis 5, wobei das zweidimensionale Material mindestens eines der folgenden Materialien aufweist: Aktivkohle, Kohlenstofffasern, von Carbid-abgeleiteter Kohlenstoff (CDC), Graphen, Graphan und Kohlenstoffnanoröh ren.

7. Tragbare elektronische Vorrichtung gemäß einem der Ansprüche 1 bis 6, wobei der Superkondensator (6) eine Vielzahl von Schichten aus zweidimensionalem Material aufweist, die übereinander liegen, wobei sich zwischen jedem benachbarten Schichtpaar ein Elektrolyt befindet.

8. Tragbare elektronische Vorrichtung gemäß einem der Ansprüche 1 bis 7, wobei der Elektrolyt mindestens einen Gelelektrolyten oder einen Flüssigkristall aufweist.

9. Tragbare elektronische Vorrichtung gemäß einem der vorhergehenden Ansprüche, wobei der Superkondensator (6) in der Lage ist, dem Positionsbestimmungsmodul und dem Telekommunikationsmodul mindestens 1 Minute lang elektrische Energie bereitzustellen.

10. Verfahren zum Betreiben einer tragbaren elektronischen Vorrichtung (10) gemäß einem der Ansprüche 1 bis 9, wobei das Verfahren zumindest aufweist:
Bereitstellen der Vorrichtung (10) mit einer herausnehmbaren und wiederaufladbaren Batterie;
Bereitstellen von elektrischer Energie aus dem Superkondensator (6) für das Positionsbestimmungsmodul und das Telekommunikationsmodul;
Ermitteln einer Position der Vorrichtung (10) über das Positionsbestimmungsmodul; und
Übermittlung der von dem Positionsbestimmungsmodul ermittelten Position der Vorrichtung über das Telekommunikationsmodul.

11. Verfahren gemäß Anspruch 10, das ferner aufweist: Empfangen einer Positionsanforderung über das Hochfrequenz-Telekommunikationsmodul, bevor die Position der Vorrichtung (10) über das Positionsbestimmungsmodul ermittelt wird, und Übertragen der der vom Positionsbestimmungsmodul ermittelten Position der Vorrichtung über das Hochfrequenz-Telekommunikationsmodul an eine Quelle der Anforderung.

12. Verfahren gemäß Anspruch 10 oder Anspruch 11, das ferner aufweist, dass Feststellen, dass die Batterie nicht in der Lage ist, elektrische Energie für das Positionsbestimmungsmodul und/oder das Hochfrequenz-Telekommunikationsmodul bereitzustellen, bevor elektrische Energie von dem Superkondensator (6) für das Positionsbestimmungsmodul und/oder das Telekommunikationsmodul bereitgestellt wird.

## Revendications

1. Dispositif électronique portable (10) comprenant au moins :
un boîtier ;
une carte de circuit principal (12) contenue dans celle-ci ;
un module de localisation de position ; et
un module de télécommunications par radiofréquence ;
dans lequel la carte de circuit principal (12) comprend une zone (18) pour recevoir une batterie amovible et rechargeable ;
**caractérisé en ce que**
la carte de circuit principal (12) comprend un ensemble de supercondensateurs (2) comprenant au moins :
un substrat (4) sur lequel peut être formé un circuit électrique ;
un supercondensateur (6) formé sur le substrat (4) et comprenant une couche de matériau bidimensionnel et un électrolyte en contact avec celle-ci ; et
un contact électriquement conducteur plan (8) formé sur le supercondensateur (6) ;
dans lequel le supercondensateur (6) est lié de façon permanente au substrat (8) ; et
l'ensemble supercondensateur (2) est situé à l'extérieur de la zone de réception de la batterie (18).

2. Dispositif électronique portable selon la revendication 1, dans lequel un circuit électrique est formé sur le substrat (4) comprenant au moins un composant électronique discret supplémentaire monté sur le substrat (4) à côté du supercondensateur (6).

3. Dispositif électronique portable selon la revendication 1 ou la revendication 2, dans lequel le substrat (4) comprend un matériau semi-conducteur.

4. Dispositif électronique portable selon l'une quelconque des revendications 1 à 3, dans lequel le substrat (4) comprend un matériau polymère thermoplastique.

5. Dispositif électronique portable selon l'une quelconque des revendications 1 à 4, dans lequel le substrat (4) est rigide.

6. Dispositif électronique portable selon l'une quelconque des revendications 1 à 5, dans lequel le matériau bidimensionnel comprend au moins l'un des éléments suivants : charbon actif, fibres de carbone, carbone dérivé de carbure, graphène, graphane et nanotubes de carbone.

7. Dispositif électronique portable selon l'une quelconque des revendications 1 à 6, dans lequel le supercondensateur (6) comprend une pluralité de couches de matériau bidimensionnel, l'une sur l'autre, avec un électrolyte entre chaque paire adjacente de couches.

8. Dispositif électronique portable selon l'une quelconque des revendications 1 à 7, dans lequel l'électrolyte comprend au moins l'un parmi un électrolyte en gel et un cristal liquide.

9. Dispositif électronique portable selon l'une quelconque des revendications précédentes, dans lequel le supercondensateur (6) est capable de fournir de l'énergie électrique au module de localisation et au module de télécommunications pendant au moins 1 minute.

10. Méthode de fonctionnement d'un dispositif électronique portable (10) selon l'une quelconque des revendications 1 à 9, la méthode comprenant au moins :
à doter le dispositif (10) d'une batterie amovible et rechargeable ;
fournir de l'énergie électrique à partir du supercondensateur (6) au module de localisation et au module de télécommunications ;
trouver une position du dispositif (10) par l'intermédiaire du module de localisation de position ; et
transmettre la position du dispositif trouvée par le module de localisation de position via le module de télécommunications.

11. Méthode selon la revendication 10, comprenant en outre la réception d'une demande de position via le module de télécommunications radiofréquence avant de trouver la position du dispositif (10) via le module de localisation de position et la transmission de la position du dispositif trouvé par le module de localisation de position via le module de télécommunications radiofréquence à une source de la demande.

12. Méthode selon la revendication 10 ou la revendication 11, comprenant en outre la détermination du fait que la batterie est incapable de fournir de l'énergie électrique à au moins l'un du module de localisation de position et du module de télécommunication radiofréquence avant de fournir de l'énergie électrique du supercondensateur (6) à au moins l'un du module de localisation de position et du module de télécommunication.
